Europäisches Patentamt

European Patent Office

Office européen des brevets

(19)

(11) **EP 1 021 585 B1**

(12) **EUROPÄISCHE PATENTSCHRIFT**

(45) Veröffentlichungstag und Bekanntmachung des Hinweises auf die Patenterteilung:
**02.04.2003 Patentblatt 2003/14**

(51) Int Cl.[7]: **C23C 14/48**, F28F 13/18

(21) Anmeldenummer: **98952691.8**

(22) Anmeldetag: **02.10.1998**

(86) Internationale Anmeldenummer:
**PCT/EP98/06283**

(87) Internationale Veröffentlichungsnummer:
**WO 99/018252 (15.04.1999 Gazette 1999/15)**

(54) **GEZIELTE EINSTELLUNG VON TROPFENKONDENSATION AUF IONENIMPLANTIERTEN OBERFLÄCHEN**

SELECTED ADJUSTMENT OF DROPWISE CONDENSATION ON ION IMPLANTED SURFACES

AJUSTEMENT CIBLE DE LA CONDENSATION EN GOUTTES SUR DES SURFACES IMPLANTEES D'IONS

(84) Benannte Vertragsstaaten:
**AT CH DE ES FR GB IT LI SE**

(30) Priorität: **06.10.1997 DE 19744080**

(43) Veröffentlichungstag der Anmeldung:
**26.07.2000 Patentblatt 2000/30**

(73) Patentinhaber: **Esytec Energie- und Systemtechnik GmbH**
**91054 Erlangen (DE)**

(72) Erfinder:
• **LEIPERTZ, Alfred**
**D-91054 Erlangen (DE)**
• **CHOI, Kyong-Hee**
**D-90419 Nürnberg (DE)**

(56) Entgegenhaltungen:
• ZHAO Q ET AL: "SURFACE MATERIALS WITH DROPWISE CONDENSATION MADE BY ION IMPLANTATION TECHNOLOGY" INTERNATIONAL JOURNAL OF HEAT AND MASS TRANSFER, Bd. 34, Nr. 11, November 1991, Seiten 2833-2835, XP000617105 in der Anmeldung erwähnt
• Q.ZHAO ET AL : "DROPWISE CONDENSATION OF STEAM ON ION IMPLANTED CONDENSER SURFACES" HEAT RECOVERY SYSTEMS &CHP, Bd. 14, Nr. 5, 1994, Seiten 525-534, XP002092416 GB in der Anmeldung erwähnt
• SONG ET AL: "DROPWISE CONDENSATION OF STEAM ON ALLOY SURFACES OBTAINED BY ION IMPLANTATION TECHNIQUE" GAOXIAO HUAXNE GONGCHENG XUEBAO, Bd. 8, 1994, Seiten 96-103, XP002092419 in der Anmeldung erwähnt

EP 1 021 585 B1

**Beschreibung**

Berührt reiner Dampf eine feste Wandoberfläche, deren Temperatur unter seiner Sattdampftemperatur liegt, so schlägt sich der Dampf auf dieser Oberfläche als Flüssigkeit nieder. Dabei kann sich die Kondensation auf zwei Arten, als Filmkondensation oder als Tropfenkondensation, vollziehen. Bei der Filmkondensation wird die Wandoberfläche vom Kondensat benetzt, so daß sich das Kondensat als ein zusammenhängender Film ausbildet. Im Gegensatz zur Filmkondensation benetzt das Kondensat bei der Tropfenkondensation die Wand nicht, und das Kondensat sammelt sich in voneinander unabhängigen Tropfen. Die Benetzbarkeit der Oberfläche ist verantwortlich für das Auftreten der jeweiligen Kondensationsart und hat eine sehr starke Wirkung auf die Höhe der möglichen Wärmeübertragungsleistung. So hat man bei der Tropfenkondensation von Wasserdampf einen vier- bis zehnfach größeren Wärmeübergangskoeffizienten gemessen[1-3], was ihre große technologische Bedeutung ausmacht.

Obwohl die Bedingungen zur Erzielung von Tropfenkondensation seit Jahrzehnten prinzipiell bekannt sind und Experimente mit Promotorschichten auch zum Teil erfolgreich waren, ist die Anwendung der Tropfenkondensation bis heute nicht über das Erprobungsstadium hinausgelangt. Die Hauptprobleme zum Erzielen der Tropfenkondensation sind, daß die wirkenden Grenzflächenphänomene wie Benetzung oder Nichtbenetzung nur unzureichend theoretisch beschrieben sind und äußerst empfindlich gegenüber der durch die im praktischen Betrieb bedingten Einflüsse wie Verschmutzung, Oxidation der Oberfläche, Adsorptionsschichten und Gaseinschlüssen sind. Oberflächendefekte (Rauhigkeit) und chemische Verunreinigungen verursachen zusätzlich die häufig beobachtete Hysterese des Benetzungswinkels, die wiederum ungünstig auf die Wärmeübertragung wirkt.

Die Ionenplantierung bzw. Ionenimplantation von N, Ar, He, H, Cr, Fe und Al in Kupferrohren wurde von Zhang, Zhao u. a. [4-6] erfolgreich zum Erreichen von Tropfenkondensation eingesetzt, der Versuch, dies mit Sb, Sn, In, Se, und Bi zu erreichen, schlug dagegen fehl. Später wurden dann noch $F^+$ und $C^+$ (aus Teflonbestrahlung erzeugt) zusammen mit $Cr^+$ bzw. $Cr^+$ alleine auf PTFEbeschichteten Oberflächen implantiert [7]. Die Methode der gleichzeitigen Plantierung bzw. Implantierung von $Cr^+$ mit anderen Ionen wurde außer mit $N^+$ auch mit $CH_4$ [8] und $C_2H_6$ [9] erprobt, wobei jeweils unterschiedliche Legierungen erzeugt wurden. Für alle diese Verfahren ist typisch und damit verfahrenskennzeichnend, daß

- nur in mehreren hintereinandergeschalteten, teils komplexen Bearbeitungsgängen diese Legierungen erzeugt werden, wie dies recht ausführlich von Zhao & Burnside [7] beschrieben ist. Diese bestehen aus Arbeitsschritten zur Entfernung von Verunreinigungen und Oxiden, Oberflächenreinigung über Sputtern mit $Ar^+$, $N^+$, $P^+$ bzw. $Cr^+$ und $N^+$ gleichzeitig und nachfolgenden Plantierungs- bzw. Implantierungsschritten,
- hohe Energiedosen für die Sputtervorgänge und Ionenimplantierungen von etwa 100 keV [7] mit Dosen von $>10^{17}$ $cm^{-2}$ benötigt werden (mit Ausnahme der ersten Versuche mittels Ionenplantierung [4], die aber lediglich eine Oberflächenbeschichtung - und keine Ionenimplantierung - darstellt mit einer Legierungsbildung aufgrund von Wärmeeinflüssen),
- Legierungen unterschiedlicher Art teils hintereinander erzeugt werden mit einem Gesamtaufbau von Schichtdicken bis zu 5 μm,
- die Auswahl der Dotierelemente und der zu nutzenden Dosierungen rein empirisch ohne theoretische-fundierte Basis getroffen wurde bzw. bezüglich der Dosierung nur festgestellt wurde, daß eine hohe Dosis die Neigung zur Tropfenbildung verbessert [10].

Mit der Erfindung wird hier ein Verfahren vorgestellt, das eine wesentliche Vereinfachung der bisherigen Verfahren darstellt und so z.B. über die Nutzung technologisch eingeführter metallischer Basismaterialien eine zudem preisgünstige Herstellung großtechnologisch nutzbarer Wärmeübertragungssysteme mit geeigneten Oberflächen erlaubt, wobei die Auswahl der Dotierelemente und der notwendigen Dosis theoretisch festgelegt werden kann. Die wesentlichen Merkmale des Verfahrens sind in Anspruch 1 definiert, bevorzugte Ausführungsformen in den Ansprüchen 2 und 3.

Im einzelnen wird dabei

- gezielt die Bildung von Oxide vor dem eigentlichen Bearbeitungsprozeß erlaubt und ohne Reinigungsgängen und Vorsputtern direkt die Ionenimplantierung durchgeführt,
- in einem großen Prozeßfenster mit Breitstahlionenquelle grundsätzlich das einfachst handhabbare Element Stickstoff zur Ionenimplantierung eingesetzt, wobei die Nutzung von Mischionen ($N_2^+$, $N^+$, $N^{++}$) verfahrensbeschleunigend (Faktor 10) die notwendige Ionendosis bereitstellt,
- eine Ionendosis von $10^{15}$ $cm^{-2}$ (aufgrund theoretischer Überlegungen) grundsätzlich als genügend angesehen, was eine geringe Energleeinstrahlung erlaubt und somit keine zusätzlichen Oberflächenschichten erzeugt und damit zu wärmetechnisch günstigeren Randbedingungen führt, und über eine Vergrößerung dieser Dosis die Stärke der Tropfenkondensation und damit die Höhe der Wärmeübertragungsleistung gezielt ermöglicht,

- weiter verfahrensvereinfachend oftmals nur ein Teilbereich der Oberfläche ionenimplantiert mit nachfolgend ganzflächig ausgebildeter Eignung zur Tropfenkondensation durch Ausgleich des Dosisgefälles aufgrund horizontaler Diffusion innerhalb des Basismaterials entlang der Oberfläche,
- anwendungsbezogen gezielt unterschiedliche Basismaterialien mit teils erheblichen Verfahrens- und Kostenvorteilen für die Ionenimplantation eingesetzt, so z.B. hart verchromtes Kupfer, chemisch vernickeltes Kupfer, oder nichtrostende Metalle wie Edelstahl, Aluminium oder Titan,
- die Stärke der Tropfenkondensation auch gezielt über die Auswahl der Dotierelemente auf Grundlage theoretischer Überlegungen aus dem Verhältnis der Dipolmomente des Dotierelementes zu dem vom Stickstoff eingestellt.

Die einzelnen Verfahrenscharakteristiken werden, soweit zusätzlich notwendig, nachfolgend genau beschrieben, wobei zunächst mit den theoretischen Überlegungen zur notwendigen Mindestdosis und zur Auswahl der Dotierelemente begonnen wird. Ausgehend von den thermodynamischen Grundlagen für den irreversiblen Vorgang der Kondensation kann über die Größe des chemischen Potentials gezeigt werden, daß zur Realisierung der Tropfenkondensation ein chemisches Potential $\Delta\mu$ gefunden und genutzt werden muß, das in gleicher Größe dem bei der Tropfenbildung entstehenden chemischen Potential $\Delta\mu_{TRB}$ entgegenwirkt und so die Erreichung des für die Standfestigkeit der Tropfenkondensation notwendigen Minimums des chemischen Potentials ermöglicht. Dies ist möglich mit der Ionenimplantation durch die Bildung eines Dipolmomentes im Basismaterial, mit dem über die Anziehungsenergie zwischen dem z.B. zur Tropfenkondensation eingesetzten Wasser und der meist metallischen Oberfläche ein entsprechendes chemisches Potential aufgebaut und bereitgestellt wird.

Die Existenz eines Tropfens ist gegeben, wenn sich Tropfen und Dampf im thermodynamischen Gleichgewicht befinden: $\mu_{Tropfen} = \mu_{Dampf}$. Unter der Annahme, daß der Dampf sich wie ein ideales Gas verhält, läßt sich der vom Radius des Tropfens abhängige Dampfdruck und daraus der Tropfenradius r berechnen nach

$$r = \frac{2 \cdot V_m \cdot \gamma}{R \cdot T_{Tr} \cdot \ln \frac{P_{Tr.D}}{P^*}} \qquad (1)$$

$V_m$ = Tropfenmolvolumen, $\gamma$ = Oberflächenspannung, R = Gaskonstante
$T_{Tr}$ = Tropfentemperatur, $P_{Tr,D}$ = Tropfendampfdruck
$P^*$ = Dampfdruck einer Flüssigkeit für eine ebene Oberfläche

Um den Kondensationsbetrieb aufrechtzuhalten, muß dieser Tropfendampfdruck stets kleiner als der Druck eines kondensierenden Dampfes $P_D$ sein. Denn eine Kondensation ist ein Stoffübertragungsvorgang, der durch den Konzentrations- bzw. Druckgradienten

$$(P_D - P_{Tr,D}) > 0$$

verursacht wird.

Die Stoffwerte $\gamma$, $\rho$ und $P^*$ in Gl.(1) sind von $T_{Tr}$ abhängig, so daß man diese Größe als Funktion von $T_{Tr}$ darstellen kann mit (nach VDI-Wärmeatlas)

$$\gamma = -0{,}2 \cdot T_{Tr}(^\circ C) + 78 \qquad (2a)$$

$$\rho = -0{,}7 \cdot T_{Tr}(^\circ C) + 1028 \qquad (2b)$$

$$P = 0{,}03 \cdot T_{Tr}(^\circ C) - 2 \qquad (2c)$$

Die Gln. (2) ergeben sich aus einer linearen Interpolation für Wasser zwischen 90°C und 100°C.
In Gl.(1) eingesetzt erhält man den Tropfenradius r in Abhängigkeit nur von $T_{Tr}$ zu

$$r = \frac{2 \cdot \tilde{M} \cdot \left(-0{,}2 \cdot T_{Tr}(°C) + 78\right)}{R \cdot T_{Tr}(K) \cdot \left(-0{,}7 \cdot T_{Tr}(°C) + 1028\right) \cdot \ln \dfrac{P_{Tr,D}}{0{,}03 \cdot T_{Tr}(°C) - 2}} \tag{3}$$

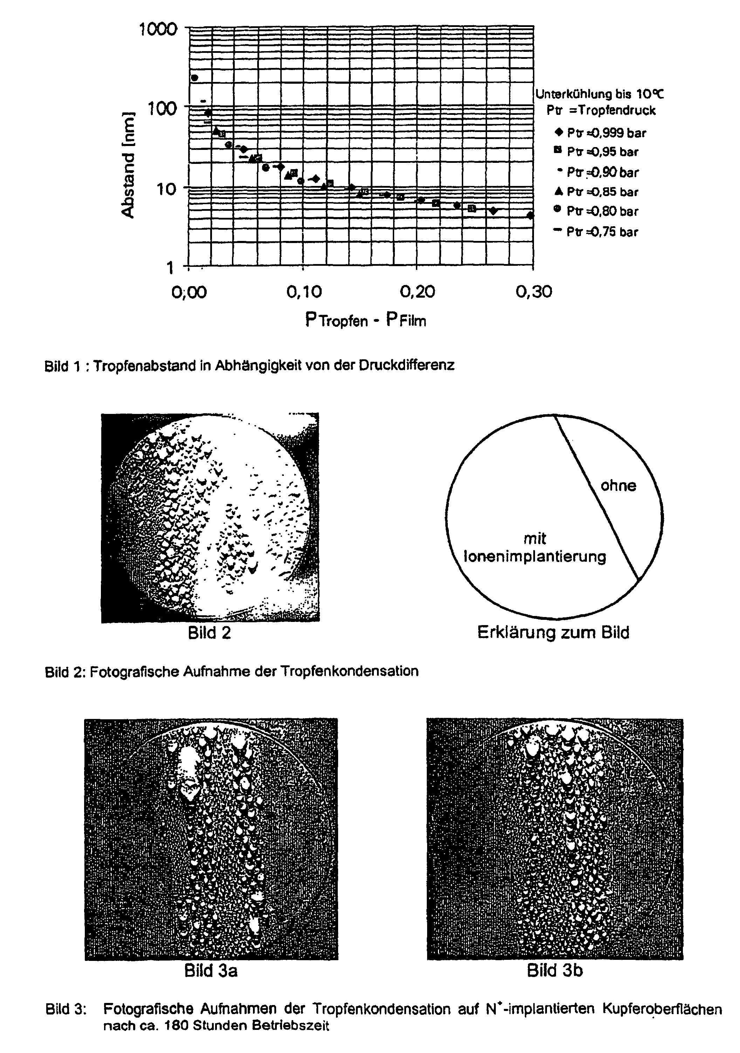

Die Dotierelementeabstände L (L=2r) wurden aus Gl.(3) bei $P_D$ = 1 bar für eine Unterkühlung des Kondensats ($\Delta T_{Unt}$ = $T_D$ - $T_{Tr}$) bis 10°C und der Änderung des Tropfendruckes von 0,75 bar bis 0,999 bar berechnet und sind in Bild 1 über die Druckdifferenz zwischen Tropfendruck und Filmdruck aufgetragen.

Bild 1 zeigt so den Bereich der Tropfengrößen zu Beginn der Kondensation. Die Tropfenradien sind sehr klein mit einem kleinsten Wert von 2 nm. Die Länge von 1 nm ist etwa die Summe von 40 Moleküldurchmessern. Der kleinste Dotierelemeteabstand L (=2·r) entspricht also etwa 160 Molekülabständen. Damit alle Dotierelemente immer die gleichen Abstände haben, müssen sie ein Dreieck bilden. In diesem Dreieck sind somit 12800 Elemente vorhanden. Die Dotierdichte beträgt also 0,023 % aller vorhandenen Elemente.

Dieses Ergebnis wurde experimentell überprüft. Da die Dotierelementeabstände von der Unterkühlung abhängen, wurde das Experiment mit verschiedenen Ionen-Dosen (Anzahl der Ionen pro Fläche) durchgeführt. Der Abstand von 1,0 nm entspricht einer Dosis von 1,0 x $10^{15}$/cm$^2$. In ersten Versuchen wurde doppelt ionisierter Stickstoff ($N^{++}$) in einer Kupferscheibe mit einem Durchmesser von 60 mm, einer Dicke von 10 mm und der Oberflächenrauhigkeit < 1μm implantiert. Bei unterschiedlich gewählten Dotierdichten (1,4x$10^{10}$ - 1,0 x $10^{15}$ cm$^{-2}$) konnte gezeigt werden, daß tatsächlich nur die höchste Dosis zur Tropfenkondensation führt In Bild 2 ist ein Beispiel dafür fotografisch festgehalten, die in einem Modellkondensator am LTT-Erlangen aufgenommen wurden. Um Tropfenkondensation zu erreichen, muß also eine Dotierdosis größer 1,0 x $10^{15}$ cm$^{-2}$ eingebracht werden.

Wie damit gezeigt, ist zweifach positiv geladener Stickstoff ($N^{++}$) als Dotierelement für die Ionenimplantierung geeignet, Versuche mit einfach positiv geladenem Stickstoff($N^+$) mit gleich hoher Dosis ergaben sogar bessere Ergebnisse mit einer deutlich günstigeren Tendenz zur Langzeithaltbarkeit (hier > 180 Stunden Betriebszeit). In Bild 3 sind Fotos der Tropfenkondensation mit $N^+$-Dotierung dargestellt (nur der mittlere Bereich ist ionenimplantiert).

Bei anfänglichen Versuchen auf rein "probierender" Basis ohne jeden theoretischen Hintergrund haben Zhang, Zhao u.a. [4-6] bei der Plantierung bzw. Implantierung eines Kupferrohres herausgefunden, daß neben den gasförmigen Dotierelementen N, He, Ar, H von den metallischen Elementen nur für Cr, Fe, Al, aber nicht für Sb, Sn, In und Bi Tropfenkondensation nachweisbar war. Ein Erklärungsversuch wurde in der Literatur nicht gegeben, in letzter Zeit aber von den Erfindern auf Basis einer Dipolmomentbildung an der Metalloberfläche aufgrund der Ionenimplantierung erfolgreich versucht. Wie vorne dargestellt ist Aufgabe der Implantation, der Erhöhung des vom Tropfenradius r abhängigen chemischen Potentials $\Delta\mu_{TRB}$ = f(r) aufgrund der Tropfenbildung entgegenzuwirken. Dies könnte durch eine Anziehungskraft W erreicht weden, die vom Dipolmoment $\theta$ und dem Atomradius der Dotierelemente $r_A$ gebildet wird ($W=\Delta\mu=f(\theta,r_A)$). Aus der Gleichheit beider chemischer Potentiale ist das geeignete Dipolmoment identifizierbar, was in den Einzelschritten hier nicht ausgeführt werden kann und bisher nur in grober Abschätzung gelungen ist. Mit Bezug auf das mit Stickstoff gebildete Dipolmoment $\theta_N$ ergibt sich so als Voraussetzung zur Bildung von Tropfenkondensation, daß das Verhältnis des Dipolmomentes des Dotierelementes i $\theta_i$ zu $\theta_N$ kleiner gleich eins sein muß

$$\theta_i/\theta_N \leq 1, \tag{4}$$

was zu einem geeigneten Atomradius $r_A \leq 63{,}3$ pm führt. In Tabelle 1 sind die Daten ($\theta_i/\theta_N$ und $r_A$) für die von Zhang, Zhao u. a. [4-6] erprobten Dotierelemente aufgeführt. Man erkennt daraus, daß mit Hilfe des entwickelten Kriteriums eine richtige Vorhersage für die Einstellung der Tropfenkondensation als Maß für eine unvollständige Benetzbarkeit der Oberfläche möglich ist, was die Gültigkeit dieser Erfindung nachweist.

Tabelle 1:

| Atomradius und stickstoffbezogenes Dipolmomentverhältnis für unterschiedliche Dotierelemente (n = Anzahl der benachbarten Atome) | | | |
|---|---|---|---|
| Elemente i | Radius [ m ] | n | $\theta_i/\theta_N$ |
| N | 6,50E-11 | - | 1 |
| Cr | 6,10E-11 | - | 0,92 |

Tabelle 1:   (fortgesetzt)

| Atomradius und stickstoffbezogenes Dipolmomentverhältnis für unterschiedliche Dotierelemente (n = Anzahl der benachbarten Atome) | | | |
|---|---|---|---|
| Elemente i | Radius [ m ] | n | $\theta_i/\theta_N$ |
| *Fe* | *6,30E-11* | *-* | *0,96* |
| *Al* | *3,90E-11* | *4* | *0,54* |
| *Al* | *5,30E-11* | *6* | *0,76* |
| Sb | 2,20E-10 | - | 9,46 |
| Se | 2.00E-10 | - | 7,66 |
| Sn | 6,90E-08 | 6 | 1,09 |
| In | 7,90E-11 | 6 | 1,33 |
| In | 9,20E-11 | 8 | 1,7 |

Auf Basis des Nutzungskriteriums nach Gl.(4) konnten weiterhin einige andere Dotierelemente für die Erzielung der Tropfenkondensation identifiziert werden, deren experimentelle Bestätigung bis heute noch nicht vollständig nachgewiesen wurde, aber als Teil dieser Erfindung hier benannt werden. Dazu gehören z.B. die Ionen von

Li,      Be,      B,      Mg,      Ga,      Ti,      und      Co.

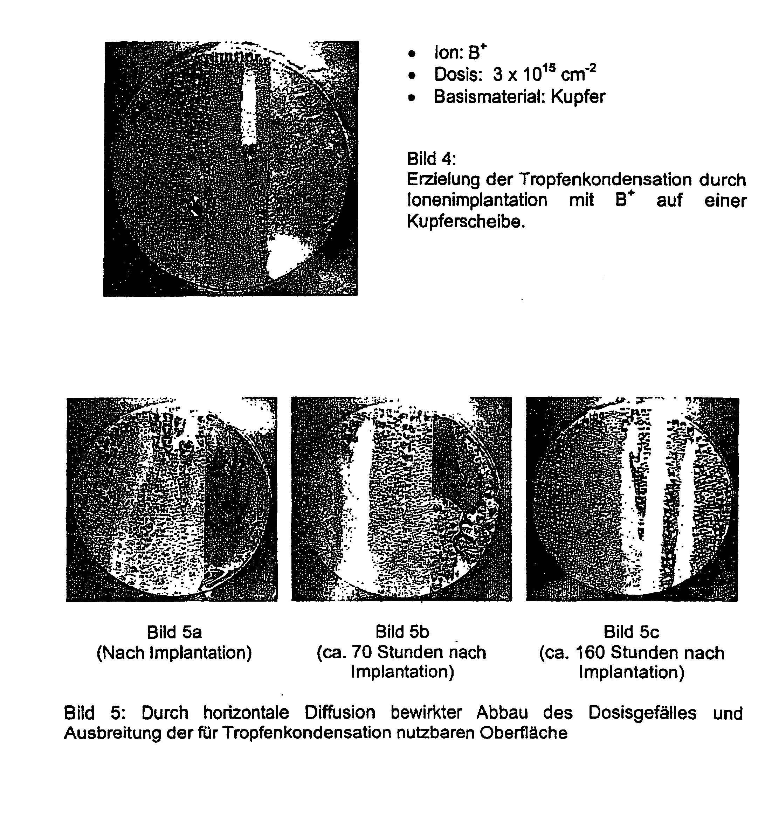

Für $B^+$ wurde dies bereits gezeigt, Bild 4(Dosis auch hier nur $10^{15}$ cm$^{-2}$).

Verfahrenstechnisch vereinfachend wird im Herstellungsprozeß oftmals nur ein Teilbereich der später für die Tropfenkondensation zu nutzenden Oberflächen mit Ionen implantiert. Durch Diffusion wird innerhalb weniger Stunden die gesamte Oberfläche für die Trofenkondensation nutzbar (Bild 5). Dies bedeutet für den Herstellungsprozeß, daß der Homogenitätsgrad bei der Herstellung der Oberflächenlegierung niedrig eingestellt werden kann, was eine weitere Reduzierung der Herstellungszeit ermöglicht. Dies wurde für wesentliche der bisher erfolgreich untersuchten Basismaterialien nachgewiesen.

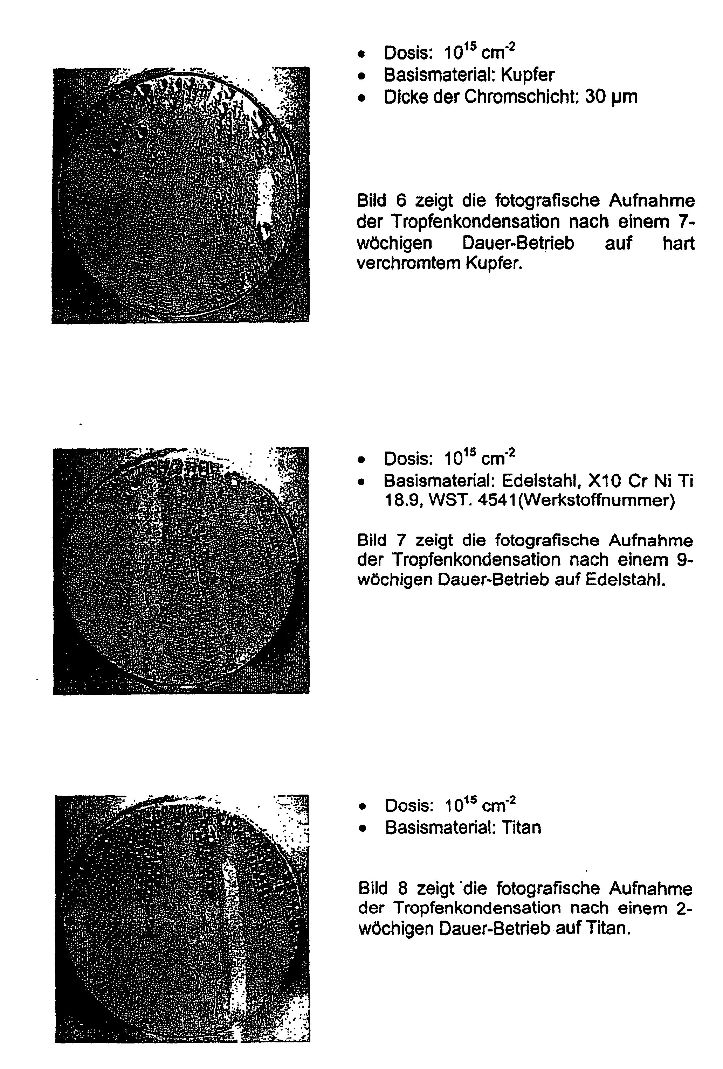

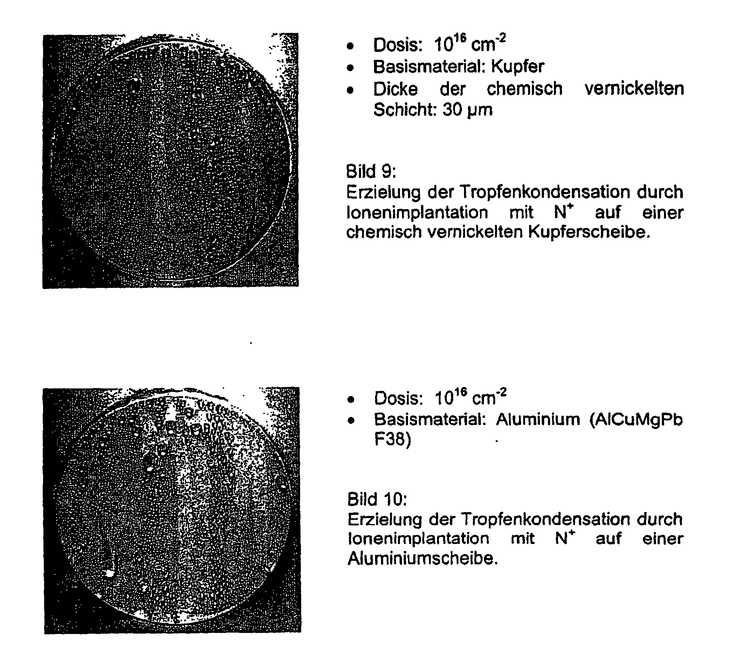

Anwendungsbezogen unterschiedlich ist oftmals die Auswahl des Basismaterials zu treffen (z.B. Titan bzw. Edelstahl für die chemische Industrie, Kupfer für Brauereibetriebe, Aluminium für gewichtssensitive Anwendungen usw). Mit verfahrenstechnisch einfacher $N^+$ - Implantierung wurde dies - wiederum ohne vorherige Arbeitsprozeduren. - erstmalig erfolgreich mit der berechneten Mindestdosis von $10^{15}$ cm$^{-2}$ neben reinem Kupfer auch auf hart verchromten Kupfer (Bild 6) durchgeführt, auch auf Edelstahl (Bild 7) und auf Titan (Bild 8) und mit erhöhter Dosis von $10^{16}$ cm$^{-2}$ auf chemisch vernickeltem Kupfer (Bild 9) und auf Aluminium (Bild 10).

Referenzstellen:

[1] Baehr, H.D., Stephan, K.
Wärme- und Stoffübertragung
Springer-Verlag, Berlin - Heidelberg (1993)

[2] Koch, G.,Zhang, D.C., Leipertz, A.
Condensation of steam on the surface of hard coated copper discs
Heat Mass Transfer 32, 149-156(1996)

[3] Koch, G., Leipertz, A.
Der Einsatz PTFE-ähnlicher Hartstoffschichten bei der Tropfenkondensation von Wasserdampf
Chemie-Ingenieur-Technik 69, 122-125 (1997)

[4] Zhang, D. C., Lin, Z. Q., Lin, J. F.
New surface materials for dropwise condensation
Proc. VIIIth Heat Transfer Conf. 4, 1677-1682 (1986)

[5] Zhao, Q., Zhang, D. C., Lin, J. F.
Surface materials with dropwise condensation made by ion implantation technology

Int. J. Heat Mass Transfer 34, 2833-2835 (1991)

[6] Zhao, Q., Zhang, D. C., Zhu, X. B., Xu, D. Q., Lin, Z. Q., Lin, J. F.
Industrial application of dropwise condensation
Proc. IXth Int. Heat Transfer Conf., Vol. 4, 391-394 (1990)

[7] Zhao, Q., Bumside, B.M.
Dropwise condensation of steam on ion implanted condenser surfaces
Heat Recovery Systems & CHP, Sept 1994, Vol.14, No.5, pp.525- 534

[8] Zhao, Q., Zhang, D.C., Li, S.D., Xu, D.Q., Lin, J.F.
Dropwise condensation of steam on ion plated surface
Proc. of International Conference on Petroleum Refining and Petrochemical Processing, Vol.2, pp.1049-1052 (1991)

[9] Zhao, Q., Liu, J.J., Bai, T., Lin, J.F., Cui, B.Y., Shen, J.L. Fang, N.F.
Dropwise condensation of steam on vertical and horizontal U- type tube condensers
Proc. 10th Heat Transfer Conference, Industrial Session, pp. 117-121(1994)

[10] Song, Y.J., Ren, X.G.
Dropwise condensation of steam on alloy surfaces obtained by ionimplantation techique
Gaoxiao Huaxue Gongcheng Xuebao, Vol.8, 96-103 (1994)

## Patentansprüche

1.  Verfahren zur gezielten Einstellung der Tropfenkondensation auf Oberflächen,
    **dadurch gekennzeichnet,**
    **daß** ohne Reinigungs- und andere Vorbereitungsschritte durch die Implantierung von Stickstoffionen oder der Ionen anderer Elemente, deren Dipolmomente kleiner gleich dem des Stickstoffs sind, mit einer theoretisch vorherbestimmten Mindestdosis vom $10^{15}$ cm$^{-2}$ die Oberflächen-Benetzungseigenschaft von reinem Kupfer, hart verchromtem Kupfer, chemisch vemickeltem Kupfer oder nichtrostenden Metallen wie Edelstahl, Aluminium oder Titan so eingestellt werden, daß sich auf ihnen stabile Tropfenkondensation ausbildet und über die Höhe der Dotierung die Stärke der Kondensation und damit die Höhe der Wärmeübertragungsleistung eingestellt wird.

2.  Verfahren zur gezielten Einstellung der Tropfenkondensation auf Oberflächen nach Anspruch 1,
    **dadurch gekennzeichnet,**
    **daß** die Ionenimplantierung über die Erzeugung und Nutzung von Mischionen um einen Faktor 10 beschleunigt durchgeführt wird.

3.  Verfahren zur gezielten Einstellung der Tropfenkondensation auf Oberflächen nach Anspruch 1 oder 2,
    **dadurch gekennzeichnet,**
    **daß** nur ein Teil der Oberfläche ionenimplantiert wird.

## Revendications

1.  Procédure visant à obtenir la formation de condensation à gouttes sur des surfaces, **caractérisée par le fait que** :

    Les propriétés de mouillage des surfaces de cuivre à l'état pur, de cuivre chromé dur, de cuivre chimiquement nickelé ou bien de métaux anti-corrosifs tels que l'acier spécial, l'aluminium ou le titan soient obtenus, sans nettoyage ou démarches de préparations préalables grâce à l'implantation d'ions d'azotes ou d'ions d'autres éléments, dont les moments dipôles sont aussi petits que ceux de l'azote, avec une dose minimale théorique déterminée au préalable de $10^{15}$ cm$^{-2}$, de sorte qu'une condensation à goutte stable se forme et que par la grandeur de la dotation, l'épaisseur de la condensation et ainsi l'intensité de la capacité de transmission de la chaleur soit réglée.

2.  Procédure visant à obtenir la formation de condensation à goutte sur des surfaces selon le point 1. **caractérisée**

**par le fait que** :

l'implantation d'ions va être effectuée par la production et
l'exploitation d'ions mélangés, augmentés au facteur 10

**3.** Procédure visant à obtenir la formation de condensation à gouttes sur des surfaces selon le point 1 ou 2 **caractérisée par le fait que** :

simplement une partie de la surface va être implantée d'ions.

## Claims

**1.** Process for the selected adjustment of dropwise condensation on surfaces **characterized in that**, by means of the implantation of nitrogen ions or of ions of other dopant elements with a dipolar element which has the same value or is smaller compared with the dipolar element of nitrogen, with a theoretically predicted minimum dose concentration of $10^{15}$ cm$^{-2}$, the wetting characteristic of the surfaces of copper, hard-chromium plated copper, chemically nickel-plated copper, or rust-proof metals such as high-grade steel, aluminium, or titanium can be adjusted without the need of cleaning or other preparation steps in such a way that stable dropwise condensation is formed on them and the intensity of the condensation and thus the heat transfer performance can be selected using the size of the dose concentration.

**2.** Process for the selected adjustment of dropwise condensation on surfaces according to claim 1, **characterized in that** the ion implantation process is conducted in an accelerated manner by a factor of 10 by the production and use of mixed ions.

**3.** Process for the selected adjustment of dropwise condensation on surfaces according to claim 1 or 2, **characterized in that** only one part of the surface is ion implanted.

Bild 1 : Tropfenabstand in Abhängigkeit von der Druckdifferenz

Bild 2

Erklärung zum Bild

Bild 2: Fotografische Aufnahme der Tropfenkondensation

Bild 3a

Bild 3b

Bild 3:    Fotografische Aufnahmen der Tropfenkondensation auf N⁺-implantierten Kupferoberflächen nach ca. 180 Stunden Betriebszeit

- Ion: $B^+$
- Dosis: $3 \times 10^{15}$ cm$^{-2}$
- Basismaterial: Kupfer

Bild 4:
Erzielung der Tropfenkondensation durch Ionenimplantation mit $B^+$ auf einer Kupferscheibe.

| Bild 5a | Bild 5b | Bild 5c |
|---|---|---|
| (Nach Implantation) | (ca. 70 Stunden nach Implantation) | (ca. 160 Stunden nach Implantation) |

Bild 5: Durch horizontale Diffusion bewirkter Abbau des Dosisgefälles und Ausbreitung der für Tropfenkondensation nutzbaren Oberfläche

- Dosis: $10^{15}$ cm$^{-2}$
- Basismaterial: Kupfer
- Dicke der Chromschicht: 30 µm

Bild 6 zeigt die fotografische Aufnahme der Tropfenkondensation nach einem 7-wöchigen Dauer-Betrieb auf hart verchromtem Kupfer.

- Dosis: $10^{15}$ cm$^{-2}$
- Basismaterial: Edelstahl, X10 Cr Ni Ti 18.9, WST. 4541(Werkstoffnummer)

Bild 7 zeigt die fotografische Aufnahme der Tropfenkondensation nach einem 9-wöchigen Dauer-Betrieb auf Edelstahl.

- Dosis: $10^{15}$ cm$^{-2}$
- Basismaterial: Titan

Bild 8 zeigt die fotografische Aufnahme der Tropfenkondensation nach einem 2-wöchigen Dauer-Betrieb auf Titan.

- Dosis: $10^{16}$ cm$^{-2}$
- Basismaterial: Kupfer
- Dicke der chemisch vernickelten Schicht: 30 µm

Bild 9:
Erzielung der Tropfenkondensation durch Ionenimplantation mit N$^+$ auf einer chemisch vernickelten Kupferscheibe.

- Dosis: $10^{16}$ cm$^{-2}$
- Basismaterial: Aluminium (AlCuMgPb F38)

Bild 10:
Erzielung der Tropfenkondensation durch Ionenimplantation mit N$^+$ auf einer Aluminiumscheibe.